Europäisches Patentamt

European Patent Office

Office européen des brevets

(11) Veröffentlichungsnummer: **0 514 840 A2**

## EUROPÄISCHE PATENTANMELDUNG

(21) Anmeldenummer: **92108441.4**

(22) Anmeldetag: **19.05.92**

(51) Int. Cl.⁵: **H01G 1/08**

(30) Priorität: **24.05.91 DE 4116960**

(43) Veröffentlichungstag der Anmeldung:
**25.11.92 Patentblatt 92/48**

(84) Benannte Vertragsstaaten:
**DE FR IT**

(71) Anmelder: **ABB PATENT GmbH
Kallstadter Strasse 1
W-6800 Mannheim 31(DE)**

(72) Erfinder: **Zengerle, Manfred
Mertelheimer Strasse 27A
W-6719 Ebertsheim(DE)**

(74) Vertreter: **Rupprecht, Klaus, Dipl.-Ing. et al
c/o ABB Patent GmbH, Postfach 10 03 51
W-6800 Mannheim 1(DE)**

(54) **Kühlvorrichtung für mindestens einen Kondensator und Verfahren zu ihrer Herstellung.**

(57) Es wird eine Kühlvorrichtung für mindestens einen Kondensator vorgeschlagen, welche eine Kühlplatte (2) aus einem gut wärmeleitenden Material mit mindestens einer Ausnehmung (4 bis 6) aufweist, deren Formgebung und Dimensionierung derjenigen eines Kondensators (16 bis 24) mit zylindrischem Gehäuse angepaßt ist, wobei Kühlkanäle (7 bis 10, 13, 29 bis 34) zum Durchfluß eines flüssigen Kühlmittels im Inneren der Kühlplatte (2) ausgebildet und über einen Kühlmittel-Eintritt (A) bzw. Kühlmittel-Austritt (B) extern anschließbar sind.

Fig. 3

EP 0 514 840 A2

Die Erfindung bezieht sich auf eine Kühlvorrichtung für mindestens einen Kondensator sowie auf verfahren zu ihrer Herstellung und kann beispielsweise bei Stromrichtergeräten, insbesondere Traktions-Stromrichtern für elektrische Schienenfahrzeuge, verwendet werden.

Aus der DE-OS 37 25 813 ist eine Kühlvorrichtung für mindestens einen Kondensator bekannt, bei der sich der mindestens eine Kondensator im Innenraum eines Siedegefäßes befindet. Eine derartige Anordnung ist möglich, da die als Siedeflüssigkeit verwendete Fluor-Chlor-Kohlenwasserstoff-Verbindung elektrisch isolierend ist. Desweiteren ist es allgemein bekannt, Beschaltungskondensatoren in ölgekühlte Stromrichtermodule einzubauen.

Aus Gründen des Umweltschutzes und des Brandschutzes ist ein Ersatz von Fluor-Chlor-Kohlenwasserstoff-Verbindungen und Isolieröl durch Wasser oder durch ein Gemisch aus Wasser und einem Frostschutzmittel erstrebenswert.

Da insbesondere nichtentionisiertes, also elektrisch leitfähiges Brauchwasser eingesetzt werden sollte, kann eine einfache Tauchkühlung bei Beschaltungskondensatoren für Stromrichter nicht mehr verwendet werden.

Bei erzwungener Flüssigkeitskühlung, wie z.B. Öldosenkühlung und Wasser-Dosenkühlung, sind Systeme entwickelt worden, die eine gute Kühlung von Halbleiterbauelementen und Beschaltungswiderständen sicherstellen. Werden Kondensatoren gemeinsam mit diesen Bauelementen in einem geschlossenen Gehäuse untergebracht, so sind besondere Maßnahmen erforderlich, um diese Kondensatoren zu kühlen.

Der Erfindung liegt die Aufgabe zugrunde, eine Kühlvorrichtung für mindestens einen Kondensator anzugeben, die in sehr einfacher Weise eine zufriedenstellende Ableitung der während des Betriebes im Kondensator entstehenden Verlustwärme gewährleistet. Ferner soll ein Verfahren zur Herstellung der Kühlvorrichtung angegeben werden.

Diese Aufgabe wird bezüglich der Kühlvorrichtung in Verbindung mit den Merkmalen des Oberbegriffes durch die im Kennzeichen des Anspruchs 1 angegebenen Merkmale gelöst.

Die Aufgabe wird bezüglich des Herstellverfahrens alternativ durch die in den Ansprüchen 7 bis 9 gekennzeichneten Merkmale gelöst.

Vorteilhafte Ausgestaltungen der Erfindung sind in den Unteransprüchen gekennzeichnet.

Die mit der Erfindung erzielbaren Vorteile liegen insbesondere darin, daß die vorgeschlagene Kühlvorrichtung einfach und robust aufgebaut ist und leicht an die Anzahl und Anordnung der zu kühlenden Kondensatoren angepaßt werden kann. d. h. die Kühlvorrichtung kann entsprechend der Anzahl der zu kühlenden Kondensatoren ein- oder beidseitig mit beliebig vielen Ausnehmungen versehen sein. Da das Gehäuse eines zylindrischen Kondensators üblicherweise nicht potentialbehaftet ist, kann auch bei Verwendung einer Kühlvorrichtung aus einem elektrisch leitfähigen Material als Kühlmittel nichtentionisiertes Wasser (Brauchwasser) verwendet werden, was aus Gründen des Umweltschutzes und des Brandschutzes von Wichtigkeit ist und wenig Aufwand erfordert. Bei mehreren Ausnehmungen parallel nebeneinander ist es durch entsprechende Ausbildung der internen Kühlkanäle möglich, daß das flüssige Kühlmittel die den verschiedenen Ausnehmungen zugeordneten Kühlkanäle parallel oder in Reihe durchströmt.

Die Kühlvorrichtung kann entweder gegossen oder mittels spanabhebender Methoden wie Bohren und Fräsen gefertigt werden. Besonders vorteilhaft ist es, ein vorgebogenes Rohr oder vorgefertigtes Rohrsystem für die Kühlkanäle heranzuziehen und dieses Rohr oder Rohrsystem mit einem gut wärmeleitenden Material, vorzusweise Aluminium, zu umgießen, wodurch die Kühlplatte geschaffen wird.

Die Erfindung wird nachstehend anhand der in der Zeichnung dargestellten Ausführungsbeispiele erläutert. Es zeigen:

| Figur 1 | eine perspektivische Ansicht auf eine Stirnseite der Kühlvorrichtung, |
| Figur 2 | eine perspektivische Seitenansicht der Kühlvorrichtung, |
| Figur 3 | einen Schnitt durch eine Kühlvorrichtung |
| Figur 4 | eine Innenansicht einer Kühlvorrichtung |
| Figur 5 | eine Anordnung mit mehreren Kühlvorrichtungen zur Kühlung mehrerer Kondensatoren, |
| Figur 6 | eine Variante zur Figur 3, |
| Figur 7,8 | Kühlvorrichtungen, bei denen ein Rohr oder Rohrsystem von einem wärmeleitenden Material umgossen ist. |

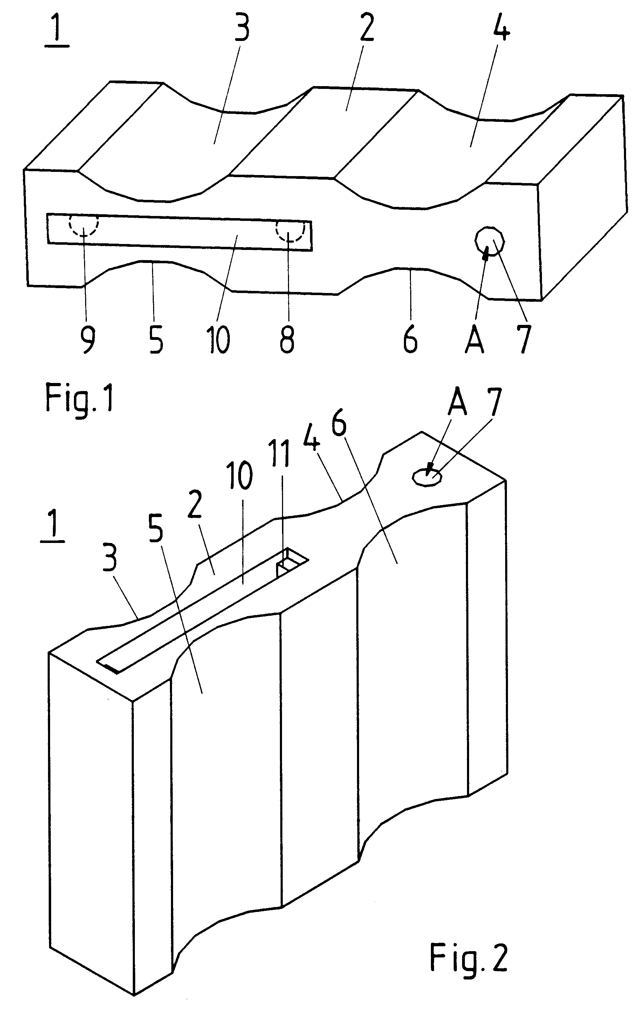

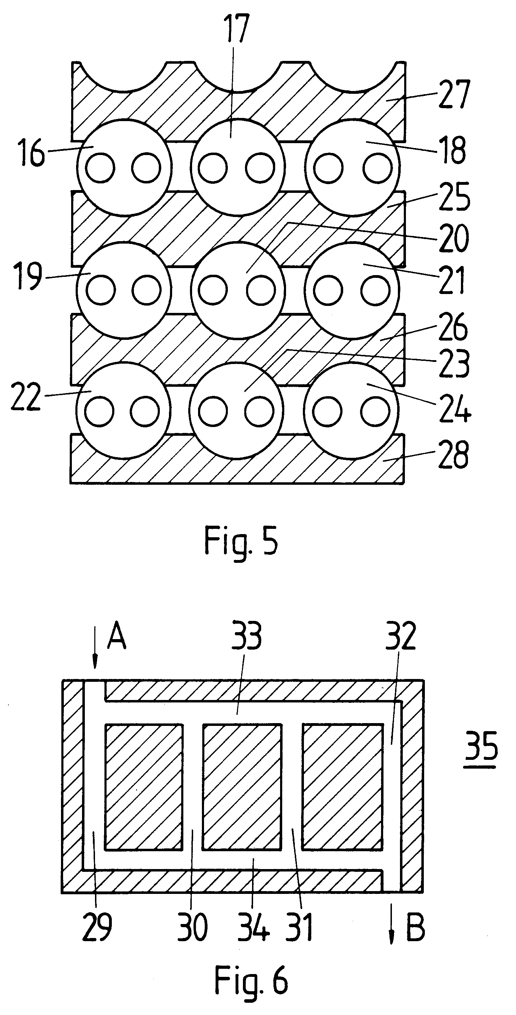

In Figur 1 ist eine perspektivische Ansicht auf eine Stirnseite der Kühlvorrichtung dargestellt. Die Kühlvorrichtung 1 besteht aus einer Kühlplatte 2, an deren erster Hauptfläche zwei Ausnehmungen 3, 4 und an deren zweiter Hauptfläche zwei weitere Ausnehmungen 5, 6 vorgesehen sind. Diese Ausnehmungen 3 bis 6 sind jeweils der Formgebungen und den Abmessungen von Kondensatoren mit zylindrischem Gehäuse angepaßt, so daß mit der in Figur 1 gezeigten Kühlvorrichtung beispielsweise vier zylindrische Kondensatoren in Kontakt gebracht werden können, wobei die Kondensatoren in zwei Reihen zu je zwei Kondensatoren anzuordnen sind. Die Kühlvorrichtung 1 kann je nach vorgegebener Kondensatoranordnung entsprechend unterschiedlich ausgebildet und dementsprechend für den Kontakt mit zwei bis acht und mehr Kondensatoren geeignet sein (Figur 5 zeigt beispielsweise Kühlvorrichtungen, deren Kühlplatte mit je sechs Kondensatoren kontaktiert werden kann).

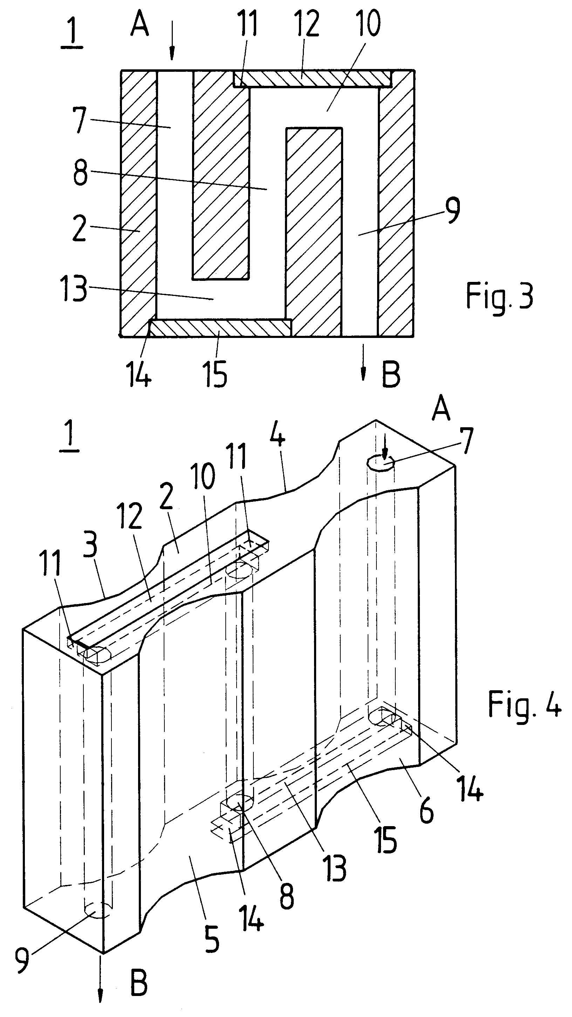

Die Kühlvorrichtung 1 besteht aus einem gut wärmeleitenden Material, beispielsweise aus Aluminium oder einer Aluminiumlegierung und weist Kühlkanäle in ihrem Inneren auf. Wie in Figur 1 zu erkennen ist, sind z.B. drei Kühlkanäle 7, 8, 9 parallel nebeneinander angeordnet, die parallel zur Hauptachse der Ausnehmungen 3 bis 6 verlaufen, wobei jeweils zwei dieser Kühlkanäle über senkrecht zu den Kühlkanälen 7, 8, 9 verlaufende Kühlkanäle im Stirnflächenbereich und Rückenflächenbereich der Kühlplatte 2 miteinander verbunden sind. In Figur 1 ist lediglich ein derartiger im Stirnflächenbereich angeordneter Kühlkanal 10 zu erkennen, der die Kühlkanäle 9 und 8 verbindet. Das weitere Ende des Kühlkanals 8 wird über einen weiteren Kühlkanal im Rückenflächenbereich (siehe Ziffer 13 gemäß Figur 3 und 4) mit dem Kühlkanal 7 verbunden. Das Kühlmittel gelangt beispielsweise über den Kühlmittel-Eintritt A in den Kühlkanal 7, von dort durch den Kühlkanal 13 in den Kühlkanal 8, von dort durch den Kühlkanal 10 in den Kühlkanal 9 und tritt von dort durch den Kühlmittel-Austritt (B gemäß Figuren 3 und 4) aus der Kühlplatte 2 aus.

Die vorstehenden Ausführungen sind vorzugsweise für eine aus einem gut wärmeleitenden Material gegossene Kühlplatte 2 gültig, d.h. bei dieser Fertigungsmethode werden sämtliche Kühlkanäle und Ausnehmungen in einem einzigen Arbeitsgang gleichzeitig mit der Herstellung der Kühlplatte geschaffen. Es ist ebenfalls möglich, die Kühlplatte 2 unter Einsatz spanabhebender Fertigungsmethoden herzustellen, d.h. hierbei werden die Kühlkanäle 7, 8, 9 durch Bohren und die Kühlkanäle 10 und 13 durch Fräsen geschaffen. Insbesondere bei dieser Fertigungsmethode ist es notwendig, die Kühlkanäle 10, 13 im Stirnflächen- und im Rückenflächenbereich der Kühlplatte durch Deckel kühlmitteldicht zu verschließen (siehe hierzu Figuren 2, 3, 4).

In Figur 2 ist eine perspektivische Seitenansicht der Kühlvorrichtung dargestellt, und zwar handelt es sich dabei um eine durch spanabhebende Fertigungsmethoden hergestellte Kühlplatte. Es sind die Ausnehmungen 3 bis 6 der Kühlplatte 2, der den Kühlmittel-Eintritt A bildende Kühlkanal 7 sowie der Kühlkanal 10 im Stirnbereich der Kühlplatte zu erkennen. Zum Aufsetzen eines den stirnbereichseitigen Kühlkanal 10 verschließenden Deckels sind Stege 11 an den Rändern des Kühlkanals 10 angeformt.

In Figur 3 ist ein Schnitt durch eine ebenfalls durch spanabhebende Fertigungsmethoden herstellbare Kühlvorrichtung dargestellt. Es ist der Kühlmittelverlauf vom Kühlmittel-Eintritt A durch die Kühlkanäle 7, 13, 8 und 9 zum Kühlmittel-Austritt B ersichtlich. Desweiteren sind die sich auf Stege 11 bzw. 14 abstützenden Deckel 12 bzw. 15 zum Verschluß der Kühlkanäle 10 und 13 zu erkennen. Diese Deckel 12, 15 sind kühlmitteldicht und druckfest zu montieren, beispielsweise zu verkleben.

In Figur 4 ist eine Innenansicht einer Kühlvorrichtung dargestellt. Es sind wiederum die Ausnehmungen 3 bis 6 der Kühlplatte 2, die Kühlkanäle 7 bis 10 und 13, die Stege 11, 14 sowie die Deckel 12, 15 zu erkennen.

In Figur 5 ist eine Anordnung mit mehreren Kühlvorrichtungen zur Kühlung mehrerer Kondensatoren dargestellt. Es ist eine aus drei Reihen mit je drei Kondensatoren bestehende Kondensatorbatterie für einen Stromrichter dargestellt, wobei die Kondensatoren 16, 17, 18 in der oberen Reihe, die Kondensatoren 19, 20, 21 in der mittleren Reihe und die Kondensatoren 22, 23, 24 in der unteren Reihe angeordnet sind. Die Kondensatoren haben jeweils zylindrische Gehäuse. Zwischen der oberen und der mittleren Reihe ist eine Kühlvorrichtung 25 derart angebracht, daß die Außenmantelflächen der Kondensatoren 16 bis 21 zum Teil jeweils in die entsprechenden Ausnehmungen der Kühlvorrichtung eingreifen, wodurch ein guter Wärmeübergang von den kontaktierten Kondensatoraußenflächen zur Kühlvorrichtung gewährleistet ist. In gleicher Art und Weise befindet sich eine weitere Kühlvorrichtung 26 zwischen den Kondensatoren 19 bis 21 der mittleren und den Kondensatoren 22 bis 24 der unteren Reihe.

Um zumindest teilweise diejenigen Teilflächen der Kondensatoren der oberen und unteren Reihe zu kühlen, die nicht mit den Kühlvorrichtungen 25 oder 26 in Kontakt treten, können - müssen jedoch nicht - weitere Kühlvorrichtungen 27 oder 28 vorgesehen sein. Die Kühlvorrichtung 27 ist beispielsweise in gleicher Weise wie die Kühlvorrichtungen 25, 26 aufgebaut und ist auf die Kondensatoren 16 bis 18 der oberen Reihe aufgesetzt. Die mit den Kondensatoren 22 bis 24 in Kontakt tretende Kühlvorrichtung 28 weist beispielsweise nur auf ihrer einen, den Kondensatoren 22 bis 25 zugewandten Hauptfläche für den Eingriff der Kondensatoren geeignete Ausnehmungen auf, während die weitere Hauptfläche eben ausgebildet ist. Welche der Varianten 27 oder 28 zum Einsatz gelangt, ist unter anderem von dem zur Verfügung stehenden Raum abhängig, da die Kühlvorrichtung 28 flacher und damit raumsparender ausgebildet ist als die Kühlvorrichtung 27.

Die Kühlmittel-Eintritte und Kühlmittel-Austritte jeder Kühlvorrichtung 25 bis 28 können parallel an zwei Hauptkühlleitungen angeschlossen, können jedoch auch in Serie hintereinander geschaltet sein. Welche der Varianten zum Einsatz gelangt, ist unter anderem von der in den Kondensatoren produzierten Wärmeleistung und von der maximal zulässigen Kondensatortemperatur abhängig.

Als Kühlmittel wird vorzugsweise nichtentionisiertes Brauchwasser verwendet.

In Figur 6 ist eine Variante zur Figur 3 dargestellt, bei der vier Kühlkanäle 29, 30, 31, 32 parallel jeweils zwischen einem mit dem Kühlmittel-Eintritt A verbundenen Kühlkanal 33 und einem mit dem Kühlmittel-Austritt B verbundenen Kühlkanal 34 angeordnet sind. Die derart ausgebildete Kühlvorrichtung ist mit Ziffer 35 bezeichnet.

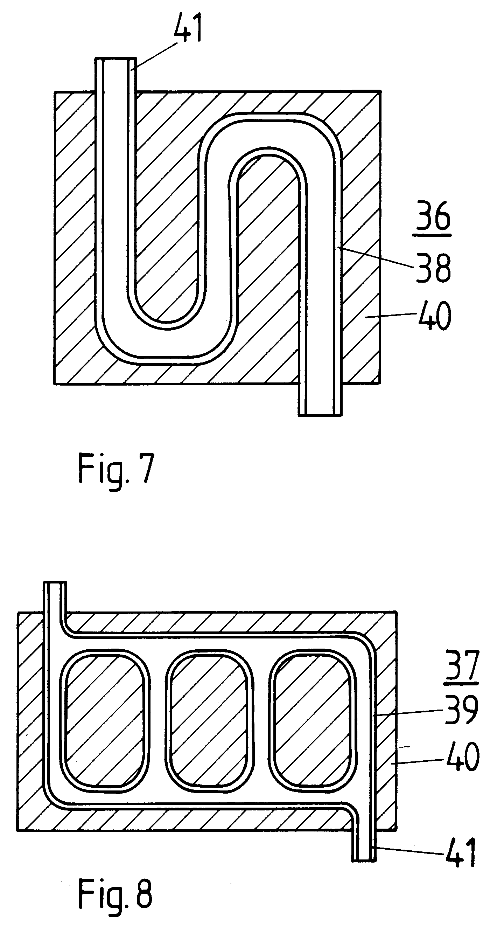

In den Figuren 7 und 8 sind Kühlvorrichtungen dargestellt, bei denen ein Rohr oder Rohrsystem von einem wärmeleitenden Material umgossen ist. Bei der Kühlvorrichtung 36 gemäß Figur 7 wird ein mäanderförmig gebogenes Rohr 38 unter Einsatz einer geeigneten Hilfsform mit einem gut wärmeleitenden Material 40 umgossen. Bei der Kühlvorrichtung 37 gemäß Figur 8 wird ein Rohrsystem 39 vorgefertigt und anschließend unter Einsatz einer geeigneten Hilfsform mit einem gut wärmeleitenden Material 40 umgossen.

Bei diesen Varianten gemäß Figuren 7 und 8 werden die Kühlkanäle demnach durch das vorgebogene Rohr 38 bzw. das vorgefertigte Rohrsystem 49 gebildet. Das Rohr bzw. Rohrsystem besteht vorzugsweise aus Kupfer oder einem anderen gut wärmeleitenden Material. Die Kühlplatte der Kühlvorrichtung wird durch das gießfähige, gut wärmeleitende Material 40 gebildet. Vorzugsweise wird hierzu Aluminium (oder eine Aluminiumlegierung) verwendet.

In den Figuren 7 und 8 ist zu erkennen, daß das Rohr 38 und das Rohrsystem 39 jeweils am Kühlmittel-Eintritt und Kühlmittel-Austritt über die Kühlplatte überstehen, wodurch Stutzen 41 geschaffen werden, die für den externen Anschluß der einzelnen Kühlvorrichtungen geeignet sind. Bedarfsweise ist es auch möglich, daß das Rohr 38 oder das Rohrsystem 39 bündig mit der Kühlplatte verlaufen.

Der Einsatz der vorstehend beschriebenen Kühlvorrichtungen für Kondensatoren erfolgt beispielsweise in Stromrichtergeräten für Fahrzeuge, insbesondere auch Schienenfahrzeuge. Während des Betriebes der Kondensatoren wird die dabei produzierte Verlustwärme an die Kühlflüssigkeit der eingesetzten Kühlvorrichtungen abgeführt. Dieser an die Kühlflüssigkeit übertragene Wärmestrom wird in einem räumlich getrennt an beliebiger Stelle auf dem Fahrzeug angeordneten Wärmeübertrager an die Umgebungsluft abgeführt.

**Patentansprüche**

1.  Kühlvorrichtung für mindestens einen Kondensator, gekennzeichnet durch eine Kühlplatte (2) aus einem gut wärmeleitenden Material mit mindestens einer Ausnehmung (3 bis 6), deren Formgebung und Dimensionierung derjenigen eines Kondensators (16 bis 24) mit zylindrischem Gehäuse angepaßt ist, wobei Kühlkanäle (7 bis 10, 13, 29 bis 34) zum Durchfluß eines flüssigen Kühlmittels im Inneren der Kühlplatte (2) ausgebildet und über einen Kühlmittel-Eintritt (A) bzw. Kühlmittel-Austritt (B) extern anschließbar sind.

2.  Kühlvorrichtung nach Anspruch 1, dadurch gekennzeichnet, daß die Kühlkanäle (7 bis 9, 29 bis 32) zum Teil parallel zur Hauptachse der mindestens einen Ausnehmung (3 bis 6) verlaufen und über weitere hierzu senkrechte, im Stirnflächen- und Rückenflächenbereich der Kühlplatte (2) angeordnete Kühlkanäle (10, 13, 33, 34) miteinander verbunden sind.

3.  Kühlvorrichtung nach Anspruch 2, dadurch gekennzeichnet, daß die im Stirnflächen- und Rükenflächenbereich der Kühlplatte (2) angeordneten Kühlkanäle (10,13) durch Deckel (12, 15) nach außen abgedichtet sind.

4.  Kühlvorrichtung nach Anspruch 3, dadurch gekennzeichnet, daß Stege (11, 14) zur Fixierung der Deckel (12, 15) am Ort der Kühlkanäle (10, 13) im Stirnflächen- und Rückenflächenbereich der Kühlplatte (2) vorgesehen sind.

5.  Kühlvorrichtung nach wenigstens einem der Ansprüche 1 bis 4, dadurch gekennzeichnet, daß lediglich eine Hauptfläche der Kühlplatte (2) mit mindestens einer Ausnehmung (3 bis 6) versehen ist.

6.  Kühlvorrichtung nach wenigstens einem der Ansprüche 1 bis 4, dadurch gekennzeichnet, daß beide Hauptflächen der Kühlplatte (2) mit jeweils mindestens einer Ausnehmung (3 bis 6) versehen sind.

7.  Verfahren zur Herstellung einer Kühlvorrichtung nach Anspruch 1, dadurch gekennzeichnet, daß spanabhebende Fertigungsmethoden, wie Bohren und Fräsen, bei der Herstellung der gut wärmeleitenden Kühlplatte und/oder Kühlkanäle eingesetzt werden.

8.  Verfahren zur Herstellung einer Kühlvorrichtung nach Anspruch 1, dadurch gekennzeichnet, daß die Kühlplatte und Kühlkanäle in einem ARbeitsgang aus einem gut wärmeleitenden Material gegossen werden.

9.  Verfahren zur Herstellung einer Kühlvorrichtung nach Anspruch 1, dadurch gekennzeichnet, daß in einem ersten Arbeitsschritt ein die Kühlkanäle bildendes Rohr vorgebogen oder ein Rohrsystem vorgefertigt werden und daß dieses Rohr oder Rohrsystem in einem zweiten Arbeitsschritt mit einem die Kühlplatte bildenden gut wärmeleitenden Material umgossen wird.

10. Verfahren nach Anspruch 9, gekennzeichnet durch den Einsatz von Kuper als Rohrmaterial.

11. Verfahren nach wenigstens einem der Ansprüche 7 bis 10, gekennzeichnet durch den Einsatz von Aluminium oder einer Aluminiumlegierung als gut wärmeleitendes Material.

Fig.1

Fig.2

Fig. 3

Fig. 4

Fig. 5

Fig. 6

Fig. 7

Fig. 8